Europäisches Patentamt

European Patent Office

Office européen des brevets

(11) Numéro de publication : **0 489 665 B1**

(12)

# FASCICULE DE BREVET EUROPEEN

(45) Date de publication du fascicule du brevet :
20.09.95 Bulletin 95/38

(51) Int. Cl.⁶ : **G01R 31/02**

(21) Numéro de dépôt : **91420396.3**

(22) Date de dépôt : **06.11.91**

(54) Contrôleur d'isolement à précision améliorée.

(30) Priorité : **28.11.90 FR 9014990**

(43) Date de publication de la demande :
**10.06.92 Bulletin 92/24**

(45) Mention de la délivrance du brevet :
**20.09.95 Bulletin 95/38**

(84) Etats contractants désignés :
**BE CH DE ES GB IT LI SE**

(56) Documents cités :
**DE-A- 3 030 295**
**GB-A- 2 181 561**
**US-A- 4 528 497**

(73) Titulaire : **SCHNEIDER ELECTRIC SA**
**40, avenue André Morizet**
**F-92100 Boulogne-Billancourt (FR)**

(72) Inventeur : **Masson, Erik**
**MERLIN GERIN - Sce. Brevets**
**F-38050 Grenoble Cedex (FR)**
Inventeur : **Lassagne, Serge**
**MERLIN GERIN - Sce. Brevets**
**F-38050 Grenoble Cedex (FR)**
Inventeur : **Magnard, Philippe**
**MERLIN GERIN - Sce. Brevets**
**F-38050 Grenoble Cedex (FR)**

(74) Mandataire : **Jouvray, Marie-Andrée et al**
**Schneider Electric SA,**
**Sce. Propriété Industrielle**
**F-38050 Grenoble Cédex 09 (FR)**

## Description

L'invention concerne un contrôleur permanent d'isolement comportant un générateur de tension d'injection, continue ou de fréquence prédéterminée différente de la fréquence du réseau à contrôler, un circuit de traitement comportant un circuit de mesure de la composante continue ou de fréquence prédéterminée de la tension appliquée à ses bornes, un microprocesseur, comportant une première entrée connectée à la sortie du circuit de mesure et comportant des moyens pour convertir le signal de sortie du circuit de mesure en une valeur numérique, calculer à partir de la valeur numérique une valeur représentative de la résistance d'isolement du réseau à contrôler, comparer la valeur représentative de la résistance d'isolement à au moins un seuil prédéterminé et sur une sortie fournir un signal d'alarme lorsque cette valeur est inférieure au seuil, et un circuit d'alarme et de signalisation connecté à la sortie du microprocesseur.

Dans un contrôleur d'isolement de ce type, pour obtenir une bonne précision pour toutes les valeurs de la résistance d'isolement, il est nécessaire d'utiliser un convertisseur analogique-numérique offrant une précision supérieure à la précision désirée, par exemple un convertisseur 12 bits.

L'invention a pour but un contrôleur d'isolement permettant d'obtenir la précision désirée tout en utilisant un convertisseur analogique numérique de précision standard, par exemple un convertisseur 8 bits.

Selon l'invention, ce but est atteint par le fait qu'il comporte, entre la sortie du circuit de mesure et une seconde entrée du microprocesseur, un circuit de grossissement comportant des moyens pour faire la différence entre le signal de sortie du circuit de mesure et une valeur de seuil prédéterminée et des moyens pour multiplier ladite différence par un coefficient multiplicateur prédéterminé.

Il est ainsi possible d'améliorer la précision pour les valeurs supérieures de la tension, correspondant aux faibles valeurs de la résistance d'isolement.

Selon un mode de réalisation particulier de l'invention, le circuit de grossissement comporte un amplificateur opérationnel dont l'entrée non inverseuse est connectée par une première résistance à la sortie du circuit de mesure et par une seconde résistance à la masse, son entrée inverseuse étant connectée par une troisième résistance à une tension de référence prédéterminée, et par une quatrième résistance à la sortie de l'amplificateur opérationnel, la première résistance ayant la même valeur que la troisième, et la seconde résistance ayant la même valeur que la quatrième.

Selon un mode de réalisation particulier de l'invention, le microprocesseur comporte des moyens pour déterminer si le signal appliqué sur sa seconde entrée est nul, et s'il est nul, pour convertir le signal appliqué sur sa première entrée. Le microprocesseur comporte également des moyens pour, si le signal appliqué sur sa seconde entrée n'est pas nul, le diviser, après conversion, par le coefficient multiplicateur, et ajouter à la valeur convertie une valeur numérique correspondant à la valeur de seuil, de manière à obtenir la valeur numérique représentative du signal de sortie du circuit de mesure.

D'autres avantages et caractéristiques ressortiront plus clairement de l'exposé qui va suivre d'un mode de réalisation particulier de l'invention, donné à titre d'exemple non limitatif et représenté aux dessins annexés sur lesquels:

La figure 1 illustre un mode particulier de réalisation du circuit de traitement du signal d'un contrôleur permanent d'isolement selon l'invention.

La figure 2 représente, en cooordonnées logarithmiques pour la résistance, la courbe de la tension en fonction de la valeur de la résistance d'isolement.

De manière classique, un contrôleur d'isolement comporte un générateur (non représenté) de tension continue, ou de tension de fréquence prédéterminée différente de la fréquence du réseau, appliquant entre la terre et le réseau à contrôler une tension de valeur prédéterminée. Un circuit de traitement mesure la tension appliquée aux bornes du contrôleur, en extrait par filtrage la composante continue ou de fréquence prédéterminée, calcule à partir de cette composante une valeur représentative de la résistance d'isolement du réseau et compare cette valeur à des seuils prédéterminés de manière à actionner une alarme lorsque la résistance d'isolement est inférieure à un de ces seuils.

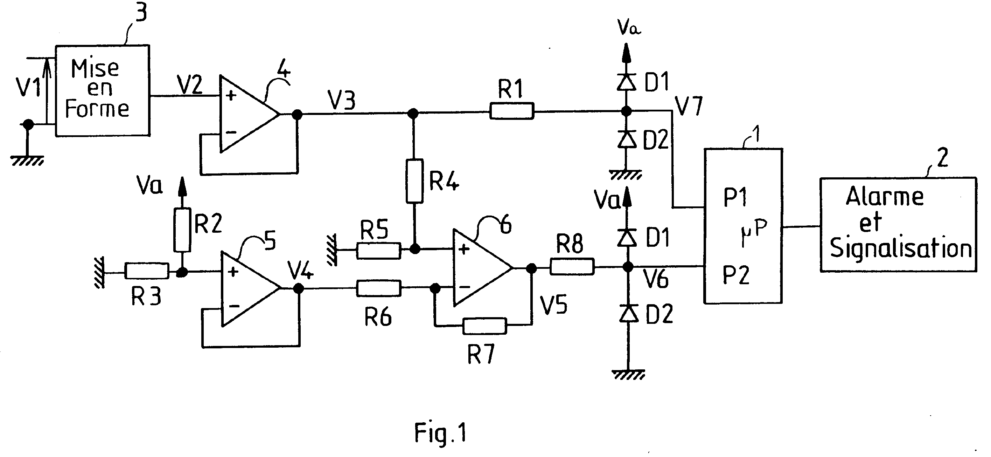

Le circuit de traitement selon la figure 1 comporte un microprocesseur 1 destiné à calculer la valeur représentative de la résistance d'isolement à partir de la tension mesurée V3, à comparer cette valeur à des seuils et, le cas échéant, à actionner un circuit d'alarme et de signalisation 2.

Le circuit de mesure auquel est appliqué un signal V1, comporte un circuit 3 de mise en forme fournissant en sortie un signal de tension continue V2, obtenu par filtrage et mise en forme de V1 et pouvant varier entre 0 et une tension d'alimentation Va, de préférence entre 0 et 5V. Le signal V2 est appliqué à une première entrée P1 du microprocesseur, de préférence par l'intermédiaire d'un circuit adaptateur d'impédance. Sur la figure ce circuit est constitué par un amplificateur opérationnel 4, dont l'entrée non inverseuse est connectée à la sortie du circuit 3 de mise en forme et dont l'entrée inverseuse est connectée à la sortie. Le signal V3 de sortie de l'amplificateur opérationnel 4 est appliqué, par l'intermédiaire d'une résistance R1 à l'entrée P1 du microprocesseur qui calcule la valeur de la résistance d'isolement correspondante.

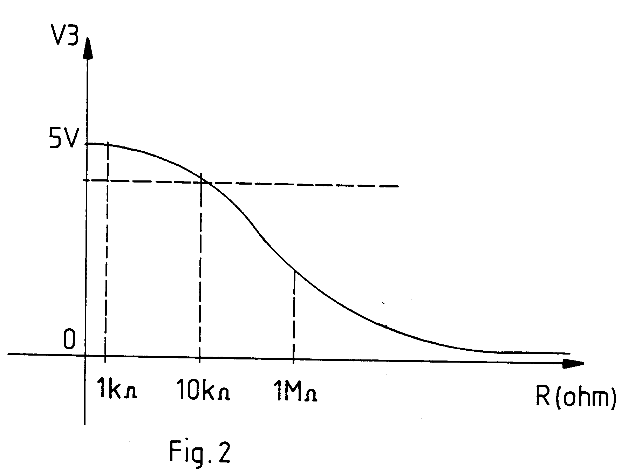

La figure 2 illustre le rapport entre la tension V3 et la résistance d'isolement R du réseau, la résistance étant représentée en coordonnées logarithmiques.

Pour une même variation en pourcentage de la valeur de la résistance d'isolement, la variation de tension mesurée est petite pour des faibles valeurs de résistance et grande pour les fortes valeurs de résistance. A titre d'exemple pour une variation de 10% de la valeur de la résistance d'isolement la variation de tension est de 112mV pour une résistance de 100KΩ et seulement de 33mV pour une résistance de 10KΩ .Avec le circuit de traitement décrit ci-dessus, la précision est insuffisante pour les valeurs faibles de la résistance d'isolement à moins d'utiliser un convertisseur analogique numérique très précis, donc coûteux.

Le circuit de traitement selon la figure 1 permet d'accroître cette précision pour les faibles valeurs de la résistance d'isolement. Ce circuit fournit une tension de référence V4. Sur la figure 1, cette tension est obtenue au moyen d'un diviseur de tension résistif constitué par deux résistances R2 et R3 connectées en série entre la tension d'alimentation Va (par exemple 5V) et la masse. Le point commun aux résistances R2 et R3 est connecté à l'entrée non inverseuse d'un amplificateur opérationnel 5 servant d'adaptateur d'impédance. Son entrée inverseuse est connectée à sa sortie sur laquelle est présente la tension de référence V4. Le signal V3 de sortie du circuit de mesure, présent à la sortie de l'amplificateur opérationnel 4 est appliqué, par l'intermédiaire d'une résistance R4, à l'entrée non inverseuse d'un amplificateur opérationnel 6, elle-même reliée à la masse par une résistance R5. La tension V4 de sortie de l'amplificateur opérationnel 5 est appliquée à l'entrée inverseuse de l'amplificateur opérationnel 6 par l'intermédiaire d'une résistance R6. Son entrée inverseuse est également reliée à la sortie de l'amplificateur 6 par une résistance R7. Les valeurs respectives des résistances sont choisies de manière à ce que : R4 = R6 et R5 = R7. L'amplificateur opérationnel 6 fonctionne en sommateur non inverseur et son signal de sortie V5 est alors donné par:

$$V5 = (V3 - V4) R7 / R6$$

A titre d'exemple, si Va = 5V, V4 peut être choisi égal à 4,5V et le rapport R7/R6 = 8. On a alors : V5 = 8 (V3 - 4,5V) Si l'on considère la figure 2, l'origine de la plage de tension supérieure à 4,5V est donc ramenée à zéro et cette plage est grossie huit fois. L'étendue de la plage concernée peut être ajustée selon les besoins, par simple modification de la valeur de seuil V4. Le coefficient multiplicateur R7/R6 est également ajusté en fonction de la précision recherchée.

Le signal V5 est appliqué à une seconde entrée P2 du microprocesseur par l'intermédiaire d'une résistance R8. Le signal de tension V6 appliqué à l'entrée P2 est limité à des valeurs acceptables par le microprocesseur au moyen de deux diodes D1 et D2 connectées respectivement entre P2 et la tension d'alimentation Va, et entre P2 et la masse. Ainsi, lorsque V4 est inférieure à V3, la tension V5 est négative, la diode D2 est alors conductrice et la tension V6 est limitée à -0,3V environ, soit un signal considéré comme nul par le microprocesseur. Tant que V5 est compris entre 0 et la tension d'alimentation, les diodes D1 et D2 sont bloquées et la tension V6 est égale à V5. Si V5 dépasse la tension d'alimentation Va, la diode D1 conduit et limite la tension V6 à une tension voisine de Va. Des diodes de protection D1 et D2 sont, de même, connectées à l'entrée P1 du microprocesseur.

Le microprocesseur 1 reçoit donc simultanément sur son entrée P1 un signal V7 représentatif de la tension mesurée V3, et sur son entrée P2 un signal V6 qui est nul si la tension mesurée est inférieure à une certaine valeur (V3 est inférieure ou égale à V4) et qui est représentatif de la différence amplifiée entre la tension mesurée et ladite valeur de seuil si la tension mesurée est supérieure à cette valeur de seuil.

Le microprocesseur, dans lequel est incorporé un convertisseur analogique-numérique, de type standard (8 bits), lit d'abord la valeur du signal V6. Si ce signal est nul, il lit la valeur du signal V7 et effectue le traitement sur la base de ce signal. Par contre, si le signal V6 n'est pas nul, c'est celui-ci qui est utilisé. Le même convertisseur analogique numérique étant utilisé pour la conversion de V7 et V6, la précision de V6 est multipliée par le coefficient multiplicateur R7/R6, par exemple par 8 dans le mode de réalisation préférentiel décrit ci-dessus. Lorsque le signal V6 n'est pas nul, après conversion, il est divisé par le coefficient multiplicateur R7/R6 et le microprocesseur ajoute à la valeur divisée une valeur numérique correspondant à la valeur du seuil V4, 4, 5V dans l'exemple considéré, de manière à obtenir une valeur numérique précise représentative de V3. Cette dernière valeur est alors traitée par le microprocesseur de la même façon que le signal V7 après conversion analogique numérique.

L'invention n'est pas limitée au mode de réalisation particulier représenté sur les figures. En particulier, il n'est pas limité au cas où le contrôleur d'isolement injecte dans le réseau une tension continue et mesure la composante continue de la tension appliquée à ses bornes. Elle s'applique de la même manière à un contrôleur d'isolement injectant dans le réseau un signal, sinusoïdal, carré, ou pseudo-carré,de fréquence prédéterminée, différente de la fréquence du réseau. Dans ce cas, la tension mesurée est obtenue, à partir de la tension aux bornes du contrôleur d'isolement, par filtrage de la fréquence du réseau.

**Revendications**

1.  Contrôleur permanent d'isolement comportant un générateur de tension d'injection, continue ou de fréquence prédéterminée différente de la fréquence du réseau à contrôler, un circuit de traitement comportant un circuit de mesure (3,4) de la composante continue ou de fréquence prédéterminée de la tension appliquée à ses bornes, un microprocesseur (1), comportant une première entrée (P1) connectée à la sortie (V3) du circuit de mesure et comportant des moyens pour convertir le signal de sortie du circuit de mesure en une valeur numérique, calculer à partir de la valeur numérique une valeur représentative de la résistance d'isolement du réseau à contrôler, comparer la valeur représentative de la résistance d'isolement à au moins un seuil prédéterminé et sur une sortie fournir un signal d'alarme lorsque cette valeur est inférieure au seuil, et un circuit d'alarme et de signalisation connecté à la sortie du microprocesseur, contrôleur caractérisé en ce qu'il comporte, entre la sortie (V3) du circuit de mesure et une seconde entrée (P2) du microprocesseur, un circuit de grossissement comportant des moyens pour faire la différence entre le signal (V3) de sortie du circuit de mesure et une valeur de seuil (V4) prédéterminée et des moyens pour multiplier ladite différence par un coefficient multiplicateur prédéterminé.

2. Contrôleur selon la revendication 1, caractérisé en ce que le circuit de grossissement comporte un amplificateur opérationnel (6) dont l'entrée non inverseuse est connectée par une première résistance (R4) à la sortie du circuit de mesure et par une seconde résistance (R5) à la masse, son entrée inverseuse étant connectée par une troisième résistance (R6) à une tension de référence prédéterminée (V4), et par une quatrième résistance (R7) à la sortie (V5) de l'amplificateur opérationnel (6), la première résistance (R4) ayant la même valeur que la troisième (R6), et la seconde résistance (R5) ayant la même valeur que la quatrième (R7).

3. Contrôleur selon la revendication 2, caractérisé en ce que chaque entrée (P1,P2) du microprocesseur est connectée à une tension d'alimentation (Va) par une première diode de protection (D1) et à la masse par une seconde diode de protection (D2).

4. Contrôleur selon l'une des revendication 1 à 3, caractérisé en ce que le microprocesseur comporte des moyens pour déterminer si le signal (V6) appliqué sur sa seconde entrée (P2) est nul, et s'il est nul, pour convertir le signal (V7) appliqué sur sa première entrée (P1).

5. Contrôleur selon la revendication 4, caractérisé en ce que le microprocesseur comporte des moyens pour, si le signal (V6) appliqué sur sa seconde entrée n'est pas nul, le diviser, après conversion, par le coefficient multiplicateur, et ajouter à la valeur convertie une valeur numérique correspondant à la valeur de seuil (V4), de manière à obtenir la valeur numérique représentative du signal de sortie du circuit de mesure.

**Patentansprüche**

1. Einrichtung zur ständigen Isolationsüberwachung, die eine Spannungsquelle zur Erzeugung einer Prüfspannung in Form einer Gleichspannung oder einer Spannung mit einer festgelegten, von der Frequenz des zu überwachenden Netzes abweichenden Frequenz, eine Signalverarbeitungsschaltung mit einem Meßkreis (3, 4) zur Erfassung des Gleichanteils bzw. des die festgelegte Frequenz aufweisenden Anteils der an seine Klemmen angelegten Spannung und einem Mikroprozessor (1), der einen ersten, an den Ausgang (V3) des Meßkreises angeschlossenen Eingang (P1) sowie Mittel zur Umwandlung des Ausgangssignals des Meßkreises in einen digitalen Wert, zur Berechnung eines, den Isolationswiderstand des zu überwachenden Netzes abbildenden Werts auf der Grundlage des digitalen Werts, zum Vergleich des den Isolationswiderstand abbildenden Werts mit mindestens einem festgelegten Schwellwert sowie zur Bereitstellung eines Alarmsignals an einem Ausgang bei Unterschreiten des Schwellwerts durch diesen Wert aufweist, sowie eine an den Ausgang des Mikroprozessors angeschlossene Alarm- und Anzeigeschaltung umfaßt, dadurch gekennzeichnet, daß die Isolations-Überwachungseinrichtung zwischen dem Ausgang (V3) des Meßkreises und einem zweiten Eingang (P2) des Mikroprozessors eine Verstärkerschaltung aufweist, welche Mittel zur Bildung der Differenz zwischen dem Ausgangssignal (V3) des Meßkreises und einem festgelegten Schwellwert (V4) sowie Mittel zur Multiplizierung der genannten Differenz mit einem festgelegten Multiplikationsfaktor umfaßt.

2. Isolations-Überwachungseinrichtung nach Anspruch 1, dadurch gekennzeichnet, daß die Verstärkerschaltung einen Operationsverstärker (6) umfaßt, dessen nicht invertierender Eingang über einen ersten Widerstand (R4) an den Ausgang des Meßkreises sowie über einen zweiten Widerstand (R5) an Masse und dessen invertierender Eingang über einen dritten Widerstand (R6) an eine festgelegte Referenzspannung (V4) sowie über einen vierten Widerstand (R7) an den Ausgang (V5) des Operationsverstärkers (6) angeschlossen ist, wobei die Werte des ersten (R4) und des dritten Widerstands (R6) sowie des zweiten (R5) und des vierten Widerstands (R7) jeweils übereinstimmen.

3. Isolations-Überwachungseinrichtung nach Anspruch 2, dadurch gekennzeichnet, daß jeder Eingang (P1, P2) des Mikroprozessors über eine erste Schutzdiode (D1) an eine Versorgungsspannung (Va) und über eine zweite Schutzdiode (D2) an Masse angeschlossen ist.

4. Isolations-Überwachungseinrichtung nach einem der Ansprüche 1 bis 3, dadurch gekennzeichnet, daß der Mikroprozessor Mittel umfaßt, um zu bestimmen, ob das an seinem zweiten Eingang (P2) anliegende Signal (V6) null ist, und, wenn dies der Fall ist, das auf seinen ersten Eingang (P2) aufgeschaltete Signal (V7) umzuwandeln.

5. Isolations-Überwachungseinrichtung nach Anspruch 4, dadurch gekennzeichnet, daß der Mikroprozessor Mittel umfaßt, um bei Abweichung des an seinem zweiten Eingang liegenden Signals (V6) von null dieses Signal nach dessen Umwandlung durch den Multiplikationsfaktor zu dividieren und den umgewandelten Wert um einen dem Schwellwert (V4) entsprechenden digitalen Wert zu erhöhen, so daß der das Ausgangssignal des Meßkreises abbildende digitale Wert erhalten wird.

**Claims**

1. A continuous insulation monitor comprising an input voltage generator, either DC or of a preset frequency different from the frequency of the mains system to be monitored, a processing circuit comprising a measuring circuit (3, 4) of the DC or preset frequency component of the voltage applied to its terminals, a microprocessor (1) comprising a first input (P1) connected to the output (V3) of the measuring circuit and cormprising means for converting the output signal of the measuring circuit into a numerical value, for computing from the numerical value a value representative of the insulation resistance of the mains system to be monitored, for comparing the value representative of the insulation resistance with at least one preset threshold and for supplying an alarm signal on an output when this value is lower than the threshold, and an alarm and signalling circuit connected to the microprocessor output, a monitor characterized in that it comprises, between the output (V3) of the measuring circuit and a second input (P2) of the microprocessor, a magnifying circuit comprising means for making the difference between the measuring circuit output signal (V3) and a preset threshold value (V4) and means for multiplying said difference by a preset multiplication coefficient.

2. The monitor according to claim 1, characterized in that the magnifying circuit comprises an operational amplifier (6) whose non-inverting input is connected by a first resistance (R4) to the measuring circuit output and by a second resistance (R5) to ground, its inverting input being connected by a third resistance (R6) to a preset reference voltage (V4), and by a fourth resistance (R7) to the output (V5) of the cperational amplifier (5), the first resistance (R4) having the same value as the third (R6), and the second resistance (R5) having the same value as the fourth (R7).

3. The monitor according to claim 2, characterized in that each input (P1, P2) of the microprocessor is connected to a supply voltage (Va) by a first protective diode (D1) and to ground by a second protective diode (D2).

4. The monitor according to one of the claims 1 to 3, characterized in that the microprocessor comprises means for determining whether the signal (V6) applied to its second input (P2) is nil, and if it is nil, for converting the signal (V7) applied to its first input (P1).

5. The monitor according to claim 4, characterized in that the microprocessor comprises means for, if the signal (V6) applied to its second input is not nil, dividing it, after conversion, by the multiplication coefficient, and adding to the converted value a numerical value corresponding to the threshold value (V4), so as to cbtain the numerical value representative of the measuring circuit output signal.

Fig.1

Fig. 2